# DEMANDE DE BREVET EUROPEEN

(11) **EP 0 923 125 A1**
(43) Date de publication de la demande: **16.06.1999**
(21) Numéro de dépôt: 98410134.5
(22) Date de dépôt: 27.11.1998
(51) Int. Cl.: H01L 21/768

(54) **Procédé de réalisation d'interconnexions métalliques dans des circuits intégrés**

(30) Priorité: 28.11.1997 FR 9715335
(71) Demandeur: STMicroelectronics SA, 94250 Gentilly Cedex (FR); FRANCE TELECOM, 75015 Paris (FR)
(72) Inventeur: Gayet, Philippe, 38660 Saint Vincent de Mercuze (FR)
(74) Mandataire: de Beaumont, Michel

(57) **Abrégé**

L'invention concerne un procédé de formation de métallisations (36) remplissant, selon un contour choisi, l'épaisseur d'une couche diélectrique (38) en un matériau difficile à graver de façon définie, cette couche diélectrique étant formée sur un support (31), comprenant les étapes consistant à former sur le support (31) une couche sacrificielle (32) ayant l'épaisseur souhaitée pour la couche dudit matériau ; ouvrir la couche sacrificielle selon ledit contour ; former des métallisations (36) dans les ouvertures ; éliminer la couche sacrificielle ; et déposer une couche (37) dudit matériau sur une épaisseur au moins égale à celle des motifs métalliques.

## Description

La présente invention concerne la fabrication de circuits intégrés semiconducteurs et plus particulièrement les étapes finales de cette fabrication au cours desquelles on réalise, au-dessus d'un substrat de silicium comportant des régions diffusées et des structures choisies, une succession de couches isolantes alternées avec des couches métalliques. Chacune des couches métalliques constitue un niveau de métallisation. Chaque niveau de métallisation est gravé selon une topologie déterminée pour établir des contacts avec des vias reliant cette couche métallique avec une couche métallique inférieure et avec une couche métallique supérieure. La couche la plus élevée est reliée à des plots de contact et la couche la moins élevée est reliée par des vias à des portions du substrat semiconducteur et/ou des régions de silicium polycristallin.

Il se pose ainsi des problèmes successifs de formation de vias à l'intérieur d'une couche diélectrique, de gravure des couches diélectriques et de gravure des couches métalliques. Divers procédés ont été développés dans la technique pour réaliser de telles couches d'interconnexion et ces procédés sont maintenant bien au point avec des matériaux classiques tels que l'oxyde de silicium et l'aluminium.

Toutefois, tandis que les progrès techniques amènent à réduire les dimensions des composants élémentaires dans le silicium, on est corrélativement amené à réduire les dimensions des motifs formés dans les diverses couches de métallisation et à rapprocher les métallisations les unes des autres. Il en résulte notamment une augmentation des capacités parasites verticales entre couches métalliques de niveaux différents et des capacités parasites latérales entre portions de métallisations d'un même niveau. Pour éviter l'augmentation de la valeur des capacités parasites, qui réduit la vitesse de commutation possible du circuit, on cherche à utiliser des diélectriques ayant des constantes diélectriques plus faibles que celle de l'oxyde de silicium. On pense notamment à utiliser divers polymères tels que les silsesquioxanes, par exemple l'hydrogène-silsesquioxane (HSQ) ou le méthyl-silsesquioxane (MSQ), des polyimides, des éthers de polyarylène, des Téflons, des parylènes ou des matériaux poreux (Aérogel). Ces diélectriques peuvent être déposés par divers procédés tels que des pulvérisations, des centrifugations, ou en phase vapeur. Toutefois, un inconvénient commun de beaucoup de ces diélectriques est qu'ils sont difficiles à graver : ou bien, lors de leur gravure par plasma, ils génèrent des sous-produits susceptibles d'endommager d'autres éléments de circuit, ou bien il est pratiquement impossible de graver dans ces matériaux des tranchées à flancs raides, ou bien leurs propriétés diélectriques se dégradent pendant les étapes de gravure ou de retrait de résine.

On a également recherché à utiliser des matériaux conducteurs plus conducteurs que l'aluminium tels que le cuivre. A nouveau, avec de tels éléments, on se retrouve devant de grandes difficultés pour graver ces matériaux de façon localisée, par exemple former des tranchées à flancs raides ou isoler électriquement les motifs entre eux.

Ainsi, un objet de la présente invention est de prévoir un nouveau procédé de réalisation de structure comprenant plusieurs niveaux conducteurs séparés par des couches isolantes traversées localement par des vias remplis de métal.

Un objet plus particulier de l'invention est de prévoir un tel procédé applicable à des matériaux diélectriques dans lesquels il n'est pas possible de réaliser des gravures localisées à flancs raides ou qu'il n'est pas possible de graver sans dégrader leurs propriétés.

Un autre objet de la présente invention est de prévoir un tel procédé dans lequel les matériaux conducteurs sont en des matériaux dans lesquels il n'est pas possible de réaliser des gravures localisées à flancs raides ou des petits espaces entre deux motifs voisins.

Pour atteindre ces objets ainsi que d'autres, la présente invention prévoit un procédé de formation de métallisations remplissant, selon un contour choisi, l'épaisseur d'une couche diélectrique en un matériau difficile à graver de façon définie, cette couche diélectrique étant formée sur un support, comprenant les étapes consistant à former sur le support une couche sacrificielle ayant l'épaisseur souhaitée pour la couche dudit matériau ; ouvrir la couche sacrificielle selon ledit contour ; former des métallisations dans les ouvertures ; éliminer la couche sacrificielle ; et déposer une couche dudit matériau sur une épaisseur au moins égale à celle des motifs métalliques.

Selon un mode de réalisation de la présente invention, l'étape de formation de métallisations dans les ouvertures comprend l'étape de dépôt d'une métallisation et de regravure par polissage mécanochimique de cette métallisation jusqu'au niveau de la surface supérieure de la couche sacrificielle.

Selon un mode de réalisation de la présente invention, ledit matériau est choisi dans le groupe des polymères tels que des polyimides, un éther de polyarylène, des silsesquioxanes, le Téflon, le parylène.

Selon un mode de réalisation de la présente invention, ledit matériau est un matériau poreux.

Selon un mode de réalisation de la présente invention, ledit matériau est déposé par centrifugation ou en phase vapeur.

Selon un mode de réalisation de la présente invention, appliqué à la formation de vias, ledit support est un niveau de métallisation intermédiaire.

Selon un mode de réalisation de la présente invention, la couche sacrificielle est une couche d'oxyde de silicium.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B représentent deux étapes de formation d'une ouverture dans un matériau tel qu'un polymère ;
les figures 2A à 2D représentent des étapes successives de formation d'interconnexions par le procédé dit "damascène" ;
les figures 3A à 3G représentent de façon générale des étapes successives d'un procédé selon la présente invention ;
les figures 4A à 4J représentent des étapes successives d'un mode de réalisation de la présente invention ; et
les figures 5A à 5G représentent des étapes successives d'un autre mode de réalisation de la présente invention.

Les diverses figures sont des vues en coupe schématiques et, conformément à l'usage dans le domaine de la représentation des composants semiconducteurs, ne sont pas tracées à l'échelle.

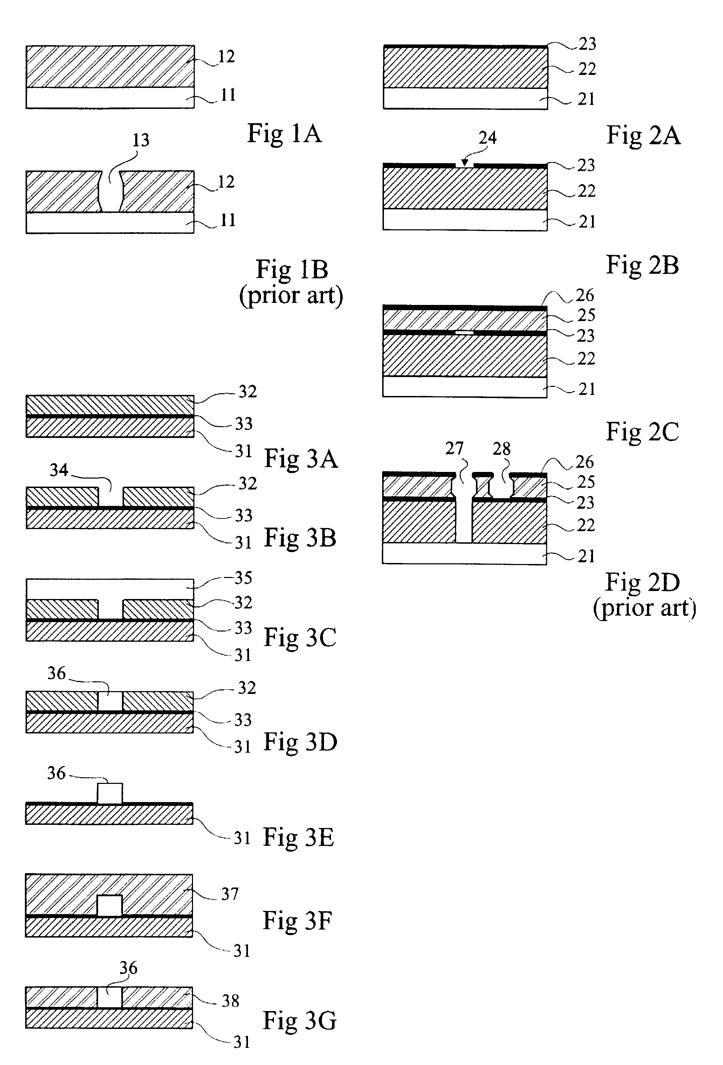

En figure 1A, on considère une couche support 11, par exemple une couche métallique constituant un niveau d'interconnexion, au-dessus de laquelle on veut déposer une couche diélectrique, former des ouvertures dans la couche diélectrique, remplir ces ouvertures d'un matériau conducteur et revêtir la couche diélectrique d'un niveau suivant de métal dans lequel on veut dessiner des interconnexions de motifs choisis.

Pour cela, de façon classique, il faut d'abord former des ouvertures aux emplacements des vias dans la couche diélectrique 12. Si on essaye de le faire dans un produit tel qu'un polymère, par des procédés de photolithographie classiques consistant à effectuer un masquage puis une gravure, on arrive à une ouverture 13 ayant le contour représenté en figure 1B, c'est-à-dire que les flancs de la section gravée sont concaves. Il en résulte que les motifs résultants vont être mal définis et que l'on aura des difficultés lors du dépôt ultérieur d'un métal destiné à remplir l'ouverture 13. En effet, ce métal aura tendance à ne pas adhérer aux parois et des lacunes se créeront. En outre, il ne sera pas possible de disposer deux lignes de métal très près l'une de l'autre. Une dégradation des propriétés du diélectrique pendant la gravure peut également se traduire par un contour concave.

Les figures 2A à 2D représentent des étapes préliminaires de formation d'interconnexions par le procédé connu dit "damascène".

Selon ce procédé, comme cela est représenté en figure 2A, en partant d'une couche métallique 21 d'un premier niveau d'interconnexion (ce premier niveau d'interconnexion peut être tout niveau d'interconnexion intermédiaire), on dépose une couche isolante 22 que l'on considérera dans cet exemple comme étant une couche d'oxyde de silicium. Puis on dépose une couche d'arrêt de gravure 23, par exemple du nitrure de silicium.

A l'étape illustrée en figure 2B, on a formé une ouverture 24 dans la couche d'arrêt de gravure 23 à l'emplacement où l'on souhaite former un via.

A l'étape illustrée en figure 2C, on dépose une deuxième couche de diélectrique 25 et une couche de masquage 26, par exemple à nouveau une couche de nitrure de silicium.

A l'étape illustrée en figure 2D, on réalise par photolithographie des ouvertures dans la couche de masquage 26. Ces ouvertures sont désignées par la référence 27 quand elles se trouvent au-dessus d'un via et par la référence 28 à des emplacements où l'on veut simplement graver la couche de diélectrique 25. Ensuite, on grave à travers ces ouvertures d'une part des tranchées sous les ouvertures 28, d'autre part, des vias sous les ouvertures 27. Des étapes ultérieures du procédé, non représentée, consistent à déposer un métal remplissant les tranchées et les vias avec dépôt éventuel antérieur d'une couche d'accrochage telle que du nitrure de titane. On procède enfin à une gravure par polissage mécanochimique de la partie du métal débordant de la surface supérieure de la couche 26 et le procédé se continue par dépôt d'une nouvelle couche de diélectrique et réalisation d'une métallisation ultérieure.

La figure 2D montre ce qui se passe quand la couche de diélectrique 25 est en un matériau non susceptible de se graver avec formation de flancs raides. On retrouve l'inconvénient illustré en figure 1B, à savoir qu'un dépôt régulier du métal dans les ouvertures sera en fait pratiquement impossible, et qu'il ne sera pas possible de prévoir des bandes métalliques très proches les unes des autres, ou alors la constante diélectrique se dégrade pendant la gravure, ce qui va à l'encontre du but recherché.

Les figures 3A à 3G représentent de façon très schématique des étapes successives d'un procédé selon la présente invention permettant d'éviter les inconvénients susmentionnés résultant de la gravure d'une couche d'un matériau diélectrique non gravable à flancs raides. Pour simplifier la description ci-après, on appellera simplement cette couche "couche de polymère".

Comme le représente la figure 3A, on part d'un support 31, qui, selon les applications de la présente invention sera une couche isolante ou un niveau de métallisation sur lequel on veut former des bandes de métal ou des vias séparés par un polymère. On dépose sur le support 31 une couche d'un matériau facilement gravable de façon classique, par exemple une couche d'oxyde de silicium 32. Une couche d'arrêt de gravure 33 est éventuellement interposée entre les couches 31 et 32.

A l'étape illustrée en figure 3B, on forme des ouvertures 34 dans la couche 32.

A l'étape illustrée en figure 3C, on a procédé à un dépôt d'une couche métallique 35 qui se forme dans les ouvertures 34 et au-dessus de la couche 32 (selon les applications, on aura éliminé ou non la couche d'arrêt de gravure au fond de l'ouverture 34).

On procède ensuite à un nivellement de la structure par polissage mécanochimique (CMP) pour éliminer le métal au-dessus de la couche 32 et l'on obtient la structure illustrée en figure 3D.

Après cela, selon la présente invention, on élimine la couche 32 qui pouvait donc être considérée comme une couche sacrificielle pour obtenir la structure représentée en figure 3E.

Alors seulement, à l'étape illustrée en figure 3F, on dépose sur l'ensemble de la structure une couche de polymère 37 qui peut être ensuite éventuellement arasée par polissage mécanochimique, comme le représente la figure 3G. On obtient ainsi des métallisations 36 de contour donné insérées dans une couche de polymère 38 ayant la même épaisseur que la couche sacrificielle 32 déposée à l'étape de la figure 3A.

On notera que ce procédé n'implique aucune étape de gravure localisée ni du métal 36, ni du polymère 37. Les matériaux de ces couches peuvent donc être des matériaux non susceptibles d'être gravés correctement par les procédés de gravure connus, tels que des procédés de gravure plasma. Il suffit que le métal puisse être nivelé par polissage mécanochimique, ce qui est le cas de tous les matériaux actuellement envisagés.

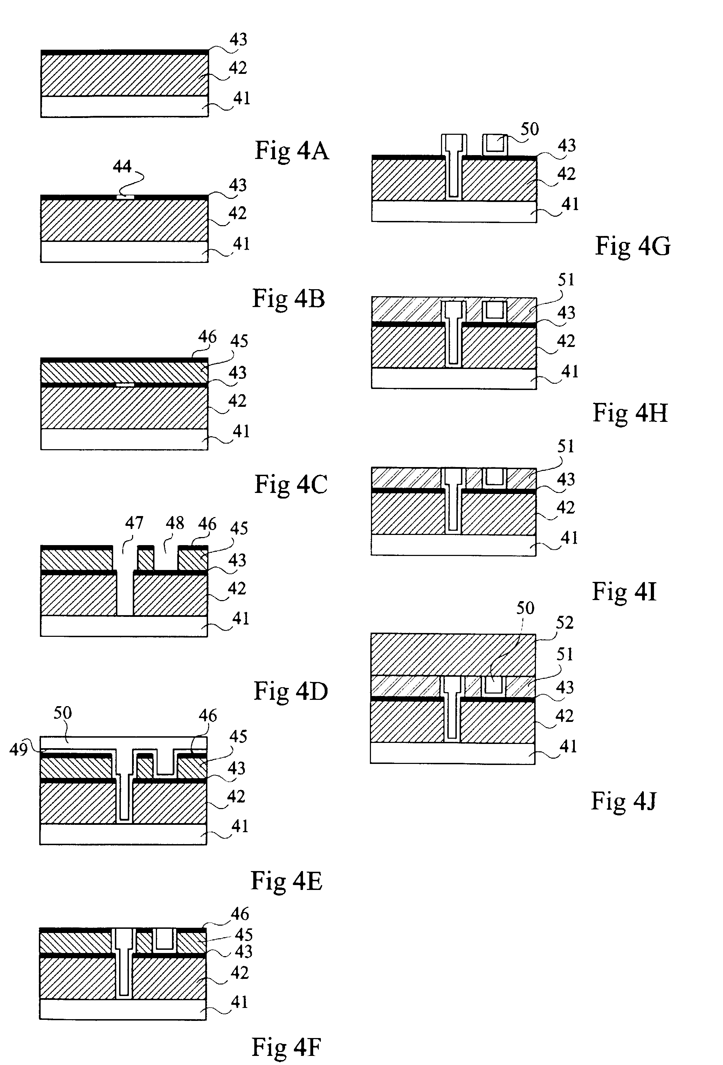

Les figures 4A à 4J illustrent une application du procédé selon la présente invention à la réalisation d'une couche d'interconnexion dans laquelle un polymère assure l'isolement latéral entre des portions de métal de contour choisi du niveau d'interconnexion considéré.

Plus particulièrement, les étapes initiales des figures 4A à 4F correspondent aux étapes d'un procédé "damascène" classique. On part d'un support 41 correspondant à un niveau de métallisation surmonté d'une couche isolante 42, par exemple en oxyde de silicium elle-même surmontée d'une couche d'arrêt de gravure 43, par exemple du nitrure de silicium (figure 4A). A l'étape illustrée en figure 4B, on forme dans la couche 43 des ouvertures 44 aux emplacements où l'on veut former des vias entre deux niveaux de métallisation. A l'étape représentée en figure 4C, on a déposé une deuxième couche 45 qui correspond à la couche sacrificielle selon la présente invention surmontée d'une couche d'arrêt de gravure 46. A l'étape illustrée en figure 4D, on a formé des ouvertures 47 et 48 dans la couche d'arrêt de gravure 46. Les ouvertures 47 se trouvent au-dessus d'emplacements de vias et les ouvertures 48 aux emplacements où l'on souhaite former des métallisations d'interconnexion. On réalise ensuite des ouvertures dans la couche 45 puis éventuellement dans la couche 42. A l'étape illustrée en figure 4E, on a déposé une métallisation, en déposant successivement par exemple une couche d'accrochage en nitrure de titane 49 et une couche 50 d'un métal tel que du cuivre ou des alliages de cuivre et d'aluminium ou du tungstène. A l'étape illustrée en figure 4F, on a réalisé un polissage mécanochimique pour araser la couche de métal 50 jusqu'au niveau de la surface supérieure de la couche d'arrêt de gravure 46.

Dans un procédé classique, la réalisation de la structure est pratiquement terminée et il reste à recouvrir la structure de la figure 4F d'une nouvelle couche d'oxyde de silicium dans laquelle on répétera les étapes illustrées à partir de la figure 4A pour former des vias et une couche d'interconnexion de niveau supérieur. Dans ce procédé classique, la couche isolante 45 est une couche définitive. Par contre, selon la présente invention, comme on l'a indiqué précédemment, la couche 45 est une couche sacrificielle et, selon la présente invention, le procédé se poursuit de la façon suivante.

A l'étape illustrée en figure 4G, on élimine la couche d'arrêt de gravure 46 et la couche sacrificielle 45, la gravure s'arrêtant de préférence au niveau de la surface supérieure de la couche d'arrêt de gravure 43. Bien entendu, la gravure est faite de façon sélective sans attaquer les portions de métal 50 au-dessus de la couche d'arrêt de gravure 43.

A l'étape illustrée en figure 4H, on dépose uniformément une couche de polymère 51.

Ensuite, de façon optionnelle, comme cela est représenté à la figure 4I, on nivelle par polissage mécanochimique la surface supérieure de la couche 51 jusqu'à affleurer au niveau des surfaces supérieures des métallisations 50. Puis, comme cela est représenté en figure 4J, on procède à un nouveau dépôt d'une couche isolante 52 et le processus se répète pour réaliser des vias et une couche d'interconnexion de niveau supérieur.

Grâce à la présente invention, on a pu obtenir comme le représente la figure 4J, des métallisations localisées 50 formant un niveau d'interconnexion et séparées latéralement par une couche isolante 51 à constante diélectrique faible. Ainsi, l'application de la présente invention illustrée en relation avec les figures 4A à 4J permet de réduire la capacité parasite latérale entre conducteurs d'un même niveau de métallisation.

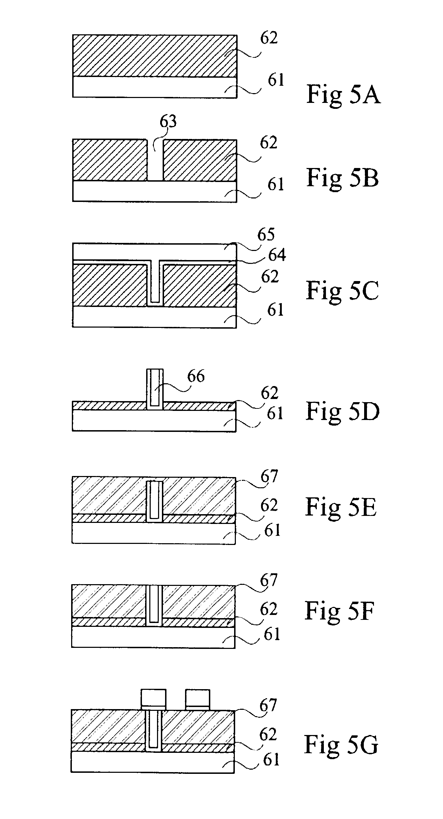

On va maintenant décrire en relation avec les figures 5A à 5G, une application de la présente invention à la réduction de la capacité parasite verticale entre deux niveaux d'interconnexion.

La figure 5A représente un support 61 correspondant à un niveau d'interconnexion sur lequel est déposée une couche 62 qui constitue une couche sacrificielle selon la présente invention.

A l'étape illustrée en figure 5B, on forme par photo-lithogravure des ouvertures dans la couche 62 aux emplacements où l'on veut former des vias entre niveaux d'interconnexion.

A l'étape illustrée en figure 5C, on a déposé uniformément une couche d'accrochage optionnelle 64 et une couche de métallisation 65. A une étape ultérieure non-représentée, on regrave par polissage mécanochimique des couches 65 et 64 jusqu'à affleurer au niveau de la surface supérieure de la couche 62.

Ensuite, on élimine la couche d'oxyde 62. Cette élimination peut être totale ou seulement partielle comme cela est représenté en figure 5D, en interrompant la gravure avant d'éliminer toute l'épaisseur de la couche 62. On laisse alors en place des vias métalliques 66.

A l'étape illustrée en figure 5E, on dépose uniformément une couche de polymère 67.

A l'étape optionnelle illustrée en figure 5F, cette couche de polymère est regravée par polissage mécanochimique jusqu'au niveau de la surface supérieure des vias métalliques 66.

On a ainsi obtenu une couche de polymère 67 dans laquelle sont insérés des vias 66 sans qu'il n'ait été nécessaire de procéder à une gravure localisée de la couche de polymère 67.

Lors d'étapes ultérieures (figure 5G), on réalise le niveau de métallisation suivant. Pour ce niveau de métallisation suivant, on pourra aussi prévoir un isolement latéral par une couche à faible constante diélectrique en utilisant le procédé illustré en figures 4A à 4J, c'est-à-dire en déposant sur la couche 67 telle qu'obtenue à l'étape de la figure 5F une couche sacrificielle, en gravant cette couche sacrificielle, en remplissant les ouvertures de la couche sacrificielle d'un conducteur, en éliminant la couche sacrificielle et en déposant une nouvelle couche de polymère.

Bien entendu, la présente invention est susceptible de diverses variantes et modifications qui apparaîtront à l'homme de métier. Notamment, comme on l'a indiqué précédemment, bien que l'on ait utilisé dans la description précédente le terme polymère, ce terme devra être interprété comme désignant tout matériau diélectrique à faible constante diélectrique, ou tout matériau diélectrique difficile à graver et/ou dans lequel la gravure peut entraîner une dégradation des profils ou des propriétés d'isolation. De plus, les diverses variantes décrites dans chaque mode de réalisation de la présente invention pourront être adoptées dans un autre mode de réalisation de l'invention. Divers matériaux conducteurs autres que du métal et divers diélectriques pourront être utilisés. Divers procédés de gravure pourront être utilisés.

## Revendications

1. Procédé de formation de métallisations (36) remplissant, selon un contour choisi, l'épaisseur d'une couche diélectrique (38) en un matériau difficile à graver de façon définie, cette couche diélectrique étant formée sur un support (31), caractérisé en ce qu'il comprend les étapes suivantes :
former sur le support (31) une couche sacrificielle (32) ayant l'épaisseur souhaitée pour la couche dudit matériau ;
ouvrir la couche sacrificielle selon ledit contour ;
former des métallisations (36) dans les ouvertures par dépôt de métal et regravure jusqu'au niveau de la surface supérieure de la couche sacrificielle ;
éliminer la couche sacrificielle ; et
déposer une couche (37) dudit matériau sur une épaisseur au moins égale à celle des motifs métalliques.

2. Procédé selon la revendication 1, caractérisé en ce que la regravure est effectuée par polissage mécanochimique.

3. Procédé selon la revendication 1, caractérisé en ce que ledit matériau est choisi dans le groupe des polymères tels que des polyimides, un éther de polyarylène, des silsesquioxanes, le Téflon, le parylène.

4. Procédé selon la revendication 1, caractérisé en ce que ledit matériau est un matériau poreux.

5. Procédé selon la revendication 1, caractérisé en ce que ledit matériau est déposé par centrifugation ou en phase vapeur.

6. Procédé selon la revendication 1, appliqué à la formation de vias, caractérisé en ce que ledit support est un niveau de métallisation intermédiaire.

7. Procédé selon l'une quelconque des revendications 1 à 4, caractérisé en ce que la couche sacrificielle est une couche d'oxyde de silicium.
